Europäisches Patentamt

European Patent Office

Office européen des brevets

(19)

(11) Publication number: **0 124 954**
**A2**

# EUROPEAN PATENT APPLICATION

(12)

(21) Application number: **84300674.3**

(22) Date of filing: **03.02.84**

(51) Int. Cl.³: **H 01 L 21/28**
**H 01 L 21/90**

(30) Priority: **05.05.83 GB 8312281**

(43) Date of publication of application:
**14.11.84 Bulletin 84/46**

(84) Designated Contracting States:
**DE FR IT NL**

(71) Applicant: **STANDARD TELEPHONES AND CABLES PUBLIC LIMITED COMPANY**
**190 Strand**
**London, WC2R 1DU(GB)**

(72) Inventor: **Scovell, Peter Denis**
**14, Staplecroft**
**Chelmsford Essex(GB)**

(72) Inventor: **Rosser, Paul John**
**120 Carters Mead Potter Street**
**Harlow Essex(GB)**

(72) Inventor: **Tomkins, Gary John**
**111, Joyners Field**
**Harlow Essex(GB)**

(74) Representative: **Dennis, Mark Charles**
**STC Patent Department Edinburgh Way**
**Harlow Essex CM20 2SH(GB)**

(54) Semiconductor devices comprising metallic silicide elements.

(57) Polysilicon elements of integrated circuits, for example gates or interconnects, are replaced by metallic silicide elements in order to take advantage of the lower resistivity thereof. The metallic silicide elements are obtained by depositing a layer of silicon rich homogenous metallic silicides on an oxidised surface (23) of a silicon substrate (20) and subsequent patterning of the layer to provide, for example, a gate element (24).

EP 0 124 954 A2

P.D.Scovell-P.J.Rosser-G.J.Tomkins 7-4-3

TITLE MODIFIED
see front page

## SEMICONDUCTOR DEVICES

This invention relates to semiconductor devices and the manufacture thereof and, in particular, to semiconductor processing employing silicides.

Polysilicon has conventionally been employed for gates and interconnections in integrated circuits. However, for small geometry, high speed integrated circuits it is desirable to use alternative materials with lower resistivity, such as silicide materials. The resistivity of polysilicon is high ($1000 \mu\Omega$cm) and roughly fifty times larger than some silicides, for example titanium disilicide has a resistivity of $20 \mu\Omega$cm, and thus interconnections of polysilicon are extremely resistive in fine-line circuits. The propagational delay of electrical signals in such interconnect lines is a function of the product of the lumped capacitance and resistance of the interconnect line. As devices sizes are scaled down to achieve higher packing densities and speeds, this delay becomes dominated by the resistive component and thus new materials must be used. Silicides comprise such alternative materials which can be entirely compatible with the other components of the manufacturing process. Provided that the introduction of the material does not significantly perturb the existing process, the advantage of the new material can also be exploited in present day technologies.

A process has been developed whereby the silicide is formed by interdiffusing a layer of metal (tungsten, molybdenum, titanium, tantalum, etc.) with a sheet of doped polysilicon used to form the conventional gate and interconnects. This heterogeneous layer is then etched to form the gate and interconnects of the device. However, because the silicide overlying the doped polysilicon etches at different rates from the polysilicon, some undesirable undercutting at the gate occurs.

An alternative process has been developed to silicide the gate and diffused regions, however this is a complex process.

The undercutting problems of the first mentioned process and the complexity of the second represent considerable barriers to the implentation of silicide into an existing process.

According to the present invention there is provided a method of manufacturing semiconductor devices including the steps of depositing a layer of a silicon rich homogeneous metallic silicide on an oxidised surface of a silicon substrate and patterning the layer to define at least one metallic silicide element on the oxidised surface.

An embodiment of the present invention will now be described with reference to the accompanying drawings, in which:-

Figs. 1a to c represent in schematic cross-section successive stages in the first-mentioned known process,

Figs 2a to c represent in schematic cross-section successive stages in the second-mentioned known process, and

Fig. 3 represents in schematic cross-section a stage in a method according to the present invention.

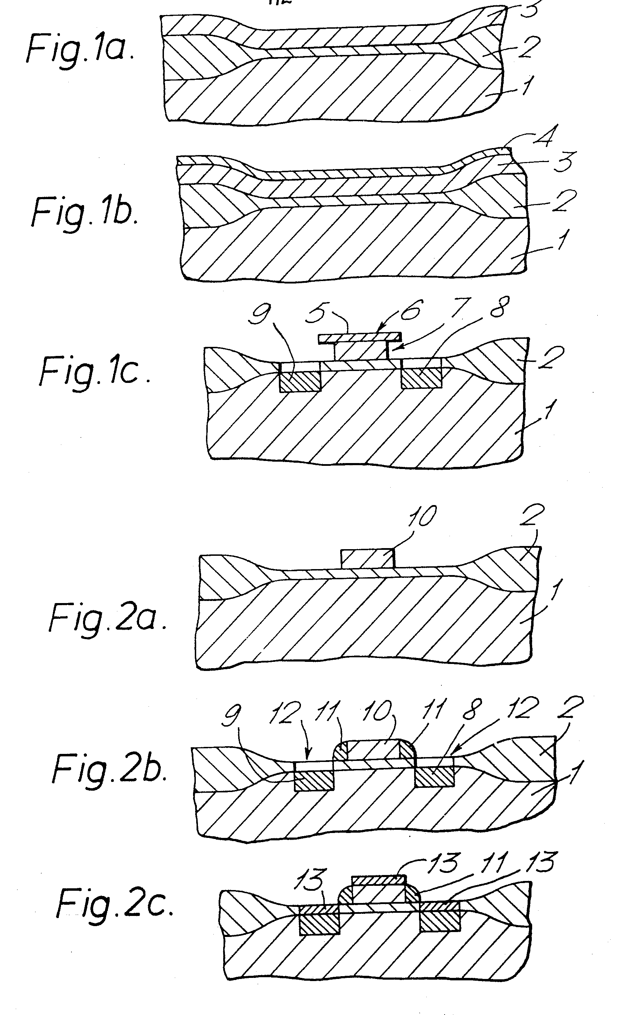

The known process shown in Figs. 1a to c comprises the following steps. On a silicon substrate 1,

0124954

an oxide layer 2, which is thin in the area where source, drain and gate regions of the device are to be formed, is provided by conventional means.   A layer of doped polycrystalline silicon (polysilicon) 3 is provided over the oxide 2 (Fig.1a).   A metal layer 4 (Fig. 1b) of, for example, tungsten, molybdenum, titanium or tantalum, is deposited on the polysilicon layer 3.   A metallic silicide layer (Fig. 1c) is formed by interdiffusing layers 3 and 4.   The structure is then etched to form the gate 6 of the device and interconnects (not shown) and, because the silicide 5 etches at a different rate from the doped polysilicon 3, undercutting as at 7 occurs.   The source 8 and drain 9 regions are next defined and implanted or diffused, and the process continues with the conventional oxidation step (intermediate oxide) (not shown), the oxidation at the silicide layer of the gate 6 relying on the diffusion of silicon from the underlying polysilicon to feed the oxidation process.   The commercial process which employs this procedure is termed the POLYCIDE process.   Adoption of the POLYCIDE process results in few changes when compared with the conventional polysilicon process, except that it introduces difficulties in etching the heterogeneous structure.

In the other known process illustrated in Figs. 2a to c and termed the SALICIDE process, both the gate interconnect, and diffused regions are silicided.   In this process a polysilicon gate 10 is defined conventionally upon oxide layer 2 on substrate 1.   A layer of CVD (Chemical Vapour Deposited) silicon dioxide is deposited over the gate 10 and interconnects (not shown) and this oxide is etched anisotropically to leave side wall spacers 11 of oxide adjacent the gate 10.   This etching serves also to open windows 12, via which the source and drain regions 8 and 9 are formed conventionally, and to remove any oxide in the contact areas and on the polysilicon 10.   A layer of metal, for example titanium, tantalum etc., is then deposited over the substrate surface and metallic silicide 13 formed by interdiffusing in a furnace the metal of the layer and the silicon.   Only in the areas of exposed silicon can the silicide form and no change occurs where the metal is deposited over oxide.   The residual (unreacted) metal is then etched away preferentially to leave the silicide 13 in the diffused, and gate interconnect areas as illustrated in Fig. 2c, together with other interconnect areas, not shown.   This method is called SALICIDE (self-aligned silicide), the silicide being self-aligned to the exposed silicon.   Processing continues with the conventional oxidation step etc.   The oxide sidewall spacers 11 introduce complexities with regard to processing, but they are essential to avoid gate to source/drain short circuits.

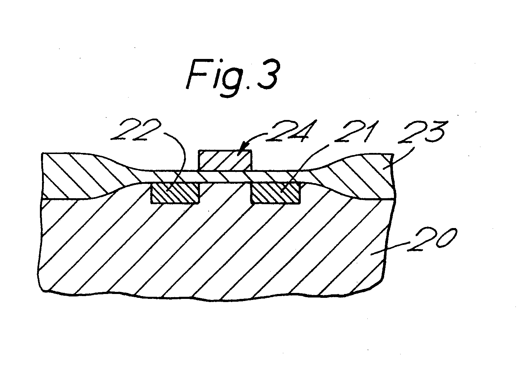

In contrast to these known processes, the method proposed by the present invention does not employ metallisation of a polysilicon layer to produce the required low resistivity silicides for gates and interconnects.   Fig. 3 illustrates a stage in the method of the present invention.   In a silicon substrate 20 source and drain regions 21 and 22 are provided by suitable processing, for example selective diffusion or implantation using the gate as a mask.   An oxide layer 23 extends over the entire surface of the substrate 20 and as illustrated is thinner in the source, drain gate regions due to the processing involved.   A gate 24 and interconnects (not shown) are provided by despositing a layer of silicon rich homogeneous metallic silicide film, by sputtering, for example, of the oxide 23.   The silicon rich silicide layer is then patterned using dry etching techniques to produce the required gates and interconnects, such as gate 24.   No undercutting results from the etching process due to the film homogeneity. The composition employed to produce the silicide film is chosen to leave the silicide perfectly formed and of the correct composition after the subsequent conventional oxidation step which uses the excess silicon as a source for oxidation.   In other words, a silicon rich silicide gate structure is deposited so that subsequent oxidation, necessary to form the device, removes the excess silicon leaving a perfectly formed and homogenous silicide. Typically the composition comprises a silicon rich silicide containing three silicon atoms to each titanium atom.   Such material should support 0.5 $\mu$m of oxide to be grown over an initial silicon rich silicide layer of thickness 0.5 $\mu$m.

The proposed process provides low interconnect resistance values whilst not disturbing the overall conventional polysilicon-based process significantly.   In addition the method avoids the etching of heterogeneous layers whilst still retaining the oxidisability of the resultant silicide.

- 6 -                                    0124954

CLAIMS:-

1. A method of manufacturing semiconductor devices characterised by the steps of depositing a layer of a silicon rich homogeneous metallic silicide on an oxidised surface (23) of a silicon substrate (20) and patterning the layer to define at least one metallic silicide element (24) on the oxidised surface.

2. A method as claimed in claim 1, characterised in that the at least one metallic silicide element comprises a gate and/or an interconnection.

3. A method as claimed in claim 1 or claim 2, characterised in that the metallic silicide layer is deposited by sputtering.

Fig.1a.

Fig.1b.

Fig.1c.

Fig.2a.

Fig.2b.

Fig.2c.

0124954

2/2

Fig. 3